Europäisches Patentamt

European Patent Office

Office européen des brevets

(19)

(11) EP 0 731 387 A2

(12) EUROPEAN PATENT APPLICATION

(43) Date of publication:
11.09.1996 Bulletin 1996/37

(51) Int Cl.⁶: G03F 7/00, H01L 21/266

(21) Application number: 96301076.4

(22) Date of filing: 16.02.1996

(84) Designated Contracting States:
BE DE FR GB

(30) Priority: 16.02.1995 KR 9502915

(71) Applicant: Samsung Electronics Co., Ltd.
Suwon-City, Kyungki-do 441-742 (KR)

(72) Inventor: Han, Woo-sung
Suwon-city, Kyungki-do (KR)

(74) Representative: Lawrence, Richard Anthony et al
Elkington & Fife,
Prospect House,
8 Pembroke Road
Sevenoaks, Kent TN13 1XR (GB)

(54) **Gray-tone mask and pattern formation and ion implantation methods using the same**

(57) A mask having a mask pattern (3) with multiple steps is provided, as are methods of forming a pattern and implanting ions using such a mask. In a mask for transcribing a mask pattern on a semiconductor substrate using light, the mask pattern includes a gray-tone mask pattern (3,103,105,107,109) in which optical transmittance is selectively varied, so that the transmittance of light passing through the mask is controlled to vary in a selective manner. When implanting ions after forming an ion implanting mask pattern on a semiconductor substrate using such a mask, the depth of ions implanted on the semiconductor substrate can be varied, and the number of masks required for frequent ion implantation processes can be reduced.

## FIG. 5A

EP 0 731 387 A2

# FIG. 5B

9a

9b

7

## Description

The present invention relates to a gray-tone mask and methods of pattern forming and implanting ions using such a mask, and more particularly, to a gray-tone mask and methods of forming an ion implantation mask pattern using such a gray-tone mask and of ion-implanting impurities using such an ion implantation mask pattern.

In general, a manufacturing process for a semiconductor device include a combination of a number of diffusion, ion implantation, photolithography and etching processes. For such a plurality of ion implantation processes in a manufacturing process, e.g., field ion implantation for forming an impurity region under a field oxide layer and source-drain ion implantation for forming source and drain regions, different dosages of $P^+$ type or $N^+$ type impurities are implanted in a semiconductor substrate. In doing so, a different photo mask is required for each implantation process, whereby separate photolithography, ion implantation and photoresist removal/cleaning processes should be performed repeatedly. With the recent trend to further integration and higher performance, the structure of semiconductor devices becomes more complicated and such repetitions in the manufacturing process tend to lower the reliability of the semiconductor device and increases the manufacturing cost. Any reduction in the number of photo masks required for ion implantation processes would thus be beneficial.

Therefore, it is an object of the present invention to provide a gray-tone mask for forming an ion implantation mask pattern on a substrate.

It is another object of the present invention to provide a method of forming an ion implantation mask pattern on a substrate using a gray-tone mask.

It is still another object of the present invention to provide a method of implanting ions using an ion implantation mask pattern.

To achieve the first object, there is provided a mask for transcribing a mask pattern on a semiconductor substrate using light, wherein the mask pattern includes a gray-tone mask pattern whose optical transmittance is selectively different, so that the transmittance of light passing through the mask is selectively and differently controlled.

The gray-tone mask pattern may comprise a photoresist pattern with multiple steps or an optical absorbing material having multiple steps with differing thicknesses. Here, the optical absorbing material may be made of one selected from the group consisting of chromium (Cr), oxide chromium (CrO), molybdenum silicon oxide (MoSiO), polysilicon, silicon nitride ($Si_3N_4$), tungsten (W) and aluminum (Al).

Preferably, the gray-tone mask pattern has a plurality of light-passing openings for controlling the transmittance of light passing through the mask. Also, the openings may have different sizes, so that the gray-tone mask pattern is divided into a plurality regions each having different transmittance.

Also, it is preferable that the gray-tone mask pattern has regions in stripes alternately disposed for passing light. Here, the width of each of the striped regions is different, so that the gray-tone mask pattern is divided into a plurality of regions each having different transmittance.

To achieve the second object of the present invention, there is provided a method of forming a pattern on a semiconductor substrate using a mask, wherein the mask comprises a gray-tone mask having selectively different optical transmittance on a mask substrate, thereby forming a pattern with multiple steps on the semiconductor substrate.

The gray-tone mask pattern may comprise a photoresist pattern with multiple steps, or an optical absorbing material with multiple steps by having differing thicknesses.

Preferably, the gray-tone mask pattern has a plurality of light-passing openings, thereby forming a pattern by controlling the optical transmittance. The gray-tone mask pattern is constructed by regions in stripes alternately disposed for passing light, thereby forming a pattern by controlling the optical transmittance.

To achieve the third object of the present invention, there is provided a method of implanting ions comprising the steps of: forming an ion implantation mask pattern on a semiconductor substrate, using a mask having a gray-tone mask pattern whose optical transmittance is selectively different; and implanting ions on the whole surface of the substrate having the ion implantation mask pattern, so that the depth of the implanted ions in the semiconductor substrate is selectively different.

The ion implantation mask pattern may comprise a photoresist pattern having multiple steps, and the gray-tone mask pattern may comprise an optical absorbing material having multiple steps with differing thickness.

Preferably, the gray-tone mask pattern has a plurality of light-passing opening for controlling the transmittance of light passing through the mask. Also, the gray-tone mask pattern is constructed by regions in stripes alternately disposed for passing light.

Preferably, there is provided a method of implanting ions comprising the steps of: forming a material layer on a semiconductor substrate; forming a mask pattern on the material layer using a mask having a gray-tone mask pattern whose transmittance is selectively different; implanting ions on the whole surface of the substrate having the mask pattern, thereby providing different ion depths within the material layer; forming an ion implantation mask pattern with multiple steps by selectively etching the ion implanted material layer; and implanting ions on the whole surface of the substrate having the ion implanting mask pattern, thereby providing different ion depths within the semiconductor substrate.

Here, the material layer may be made of one selected from the group consisting of polysilicon, oxide, silicon nitride and aluminum.

Preferably, there is provided a method of implanting ions comprising the steps of: forming a material layer on a semiconductor substrate; forming a mask pattern on the material layer using a mask having a gray-tone mask pattern whose optical transmittance is selectively different; implanting ions on the whole surface of the material layer; forming an ion implantation mask pattern with multiple steps by etching-back the mask pattern and the material layer without selectivity; and implanting ions on the whole surface of the substrate having the ion implanting mask pattern, thereby providing different ion depths within the semiconductor substrate.

Here, the mask pattern may be composed of a photoresist.

Preferably, there is provided a method of implanting ions on a semiconductor substrate using an ion implanting mask pattern as a mask, wherein the ion implanting mask pattern is formed using a mask having a gray-tone mask pattern whose optical transmittance is selectively different, thereby ion-implanting various impurities in the semiconductor substrate using one mask.

According to the present invention, an ion implantation mask pattern is formed on a semiconductor substrate using a gray-tone mask whose optical transmittance is selectively different, so that ions can be implanted at different depths to thereby reduce the number of the masks required for the ion implantation processes of a semiconductor device.

Specific embodiments of the present invention are described in detail below, by way of example, with reference to the attached drawings, in which:

FIGS. 1A and 1B are a section view and plan view showing an example of a gray-tone mask according to the present invention;

FIG. 2 is a plan view showing another example of a gray-tone mask according to the present invention;

FIG. 3 is a plan view showing still another example of a gray-tone mask according to the present invention;

FIG. 4 is a plan view showing yet another example of a gray-tone mask according to the present invention;

FIGS. 5A-5C are diagrams for illustrating the forming of a photoresist layer pattern as a mask layer on a substrate, using the mask according to an embodiment of the present invention;

FIG. 6 is a diagram illustrating the correlation between remaining photoresist thickness and the exposure dose for developing a photoresist layer formed on the substrate;

FIGS. 7 and 8 are diagrams for illustrating the implanting of ions in a semiconductor substrate on which an ion implantation mask layer is formed, according to the first preferred embodiment of the present invention;

FIGS. 9A-9E are diagrams for illustrating the implanting of ions with varying methods of forming the ion implantation mask layer, according to the second preferred embodiment of the present invention; FIGS. 10A-10D are diagrams for illustrating the implanting of ions with varying methods of forming the ion implantation mask layer, according to the third preferred embodiment of the present invention; and FIGS. 11A-11C are diagrams showing an example of the actual semiconductor device adopting an ion implantation method according to an embodiment of the present invention.

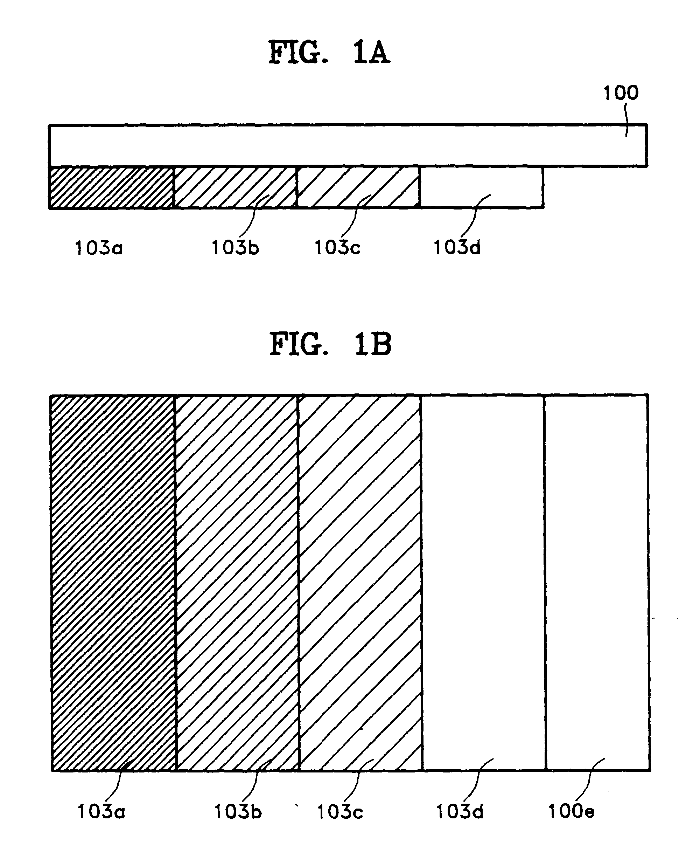

Referring to FIGS. 1A and 1B, gray-tone mask patterns 103a, 103b, 103c and 103d, which vary in transmittance as they differ in photo-absorption, are formed on a mask substrate 100. Here, reference numeral 100e is used to denote the material of mask substrate 100, e. g., glass.

In a preferred embodiment of the present invention, a chromium layer is used for gray-tone mask patterns 103a~103d. For example, since the transmittance of a 1,000Å-thick chromium layer is nearly zero at wavelengths below 500nm, an intended transmittance can be obtained at an intended wavelength by varying the thickness of the chromium layer in the range of 0Å to 1,000Å. Besides chromium (Cr), gray-tone mask patterns 103a~103d may use chromium oxide (CrO), molybdenum silicon oxide (MoSiO), polysilicon, silicon nitride ($Si_3N_4$), tungsten (W) or aluminum (Al). Again, gray-tone mask patterns 103a~103d may consist of photoresist patterns of differing thickness. Here, pattern thickness versus optical transmittance in view of wavelength can be obtained from material handbooks or, by using ellipsometry, from refractive index and extinction coefficient.

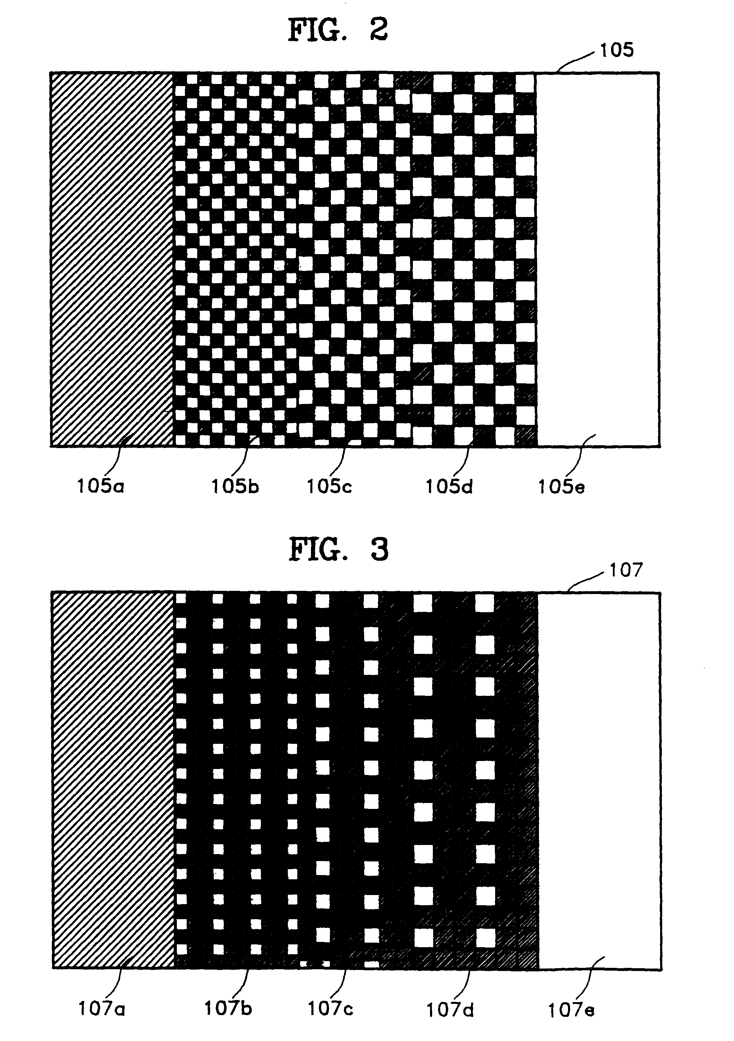

FIG. 2 is a plan view showing another example of a gray-tone mask according to the present invention.

Referring to FIG. 2, gray-tone mask 105 is divided into predetermined regions comprising gray-tone mask patterns 105a, 105b, 105c, 105d and 105e, which vary in optical transmittance from left to right. As in FIG. 1, reference numeral 105e denotes the material of the mask substrate.

A part of gray-tone mask patterns 105a-105d has a checkered structure, and optical transmittance is controlled by varying the size of the openings (white checks) therein. Here, gray-tone mask patterns 105a-105d may be formed of one selected from the group consisting of chromium, chromium oxide, molybdenum silicon oxide, polysilicon, silicon nitride, tungsten and aluminum. Opening size can be determined from the optical density, which should be less than the resolution limit in a stepper optical system. Otherwise, the openings themselves are transcribed onto the semiconductor substrate, thereby causing a problem.

FIG. 3 is a plan view showing still another example of a gray-tone mask according to the present invention.

In a gray-tone mask 107 of FIG. 3, comprising gray-tone mask patterns 107a, 107b, 107c and 107d, the arrangement of the openings is different from that of FIG. 2. A part of gray-tone mask patterns 107a~107d has a latticed shape, and the size of openings located in each of gray-tone mask patterns 107a~107d is varied, so that optical transmittance changes from left to right. Reference numeral 107e denotes the material of the mask substrate, e.g., glass. The shape of the openings may be generally polygonal, rather than only square. The size of openings can be determined from the optical density, which should be less than the resolution limit in a stepper optical system. If they are not, the openings themselves are transcribed on the semiconductor substrate, thereby causing a problem. Gray-tone mask patterns 107a~107d may consist of chromium, chromium oxide, molybdenum silicon oxide, polysilicon, silicon nitride, tungsten or aluminum.

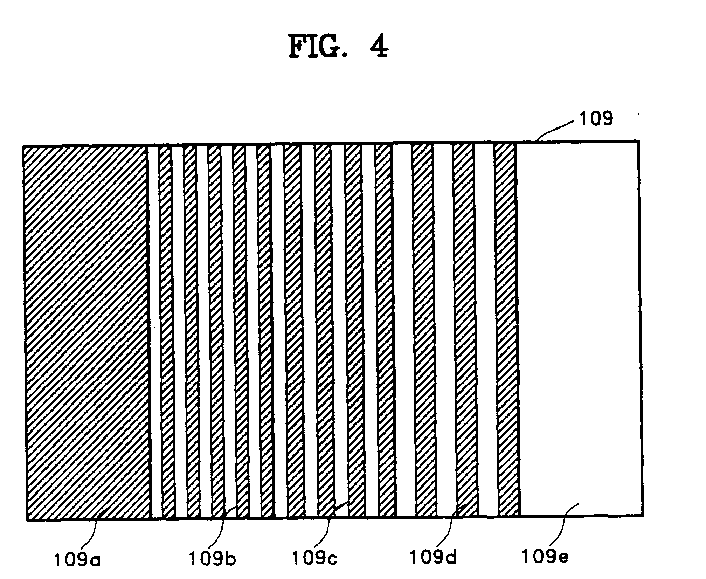

FIG. 4 is a plan view showing yet another example of a gray-tone mask according to the present invention.

Gray-tone mask 109 of FIG. 4 showing an example of controlling the transmittance according to a periodic line. Here, the width of gray-tone mask patterns 109a, 109b, 109c and 109d is varied, so that the transmittance is changed from left to right. Reference numeral 109e denotes the material of the mask substrate, e.g., glass. Gray-tone mask patterns 109a~109d may be formed of a chromium layer, chromium oxide, molybdenum silicon oxide, polysilicon, silicon nitride, tungsten or aluminum. According to gray-tone mask 109 shown in FIG. 4, the transmittance is controlled using lines formed in the material layer constituting the gray-tone mask patterns. The width of the lines should be less than the resolution limit in a stepper optical system. Otherwise, the line width is transcribed on the semiconductor substrate, thereby causing a problem.

Next, a further example of a gray-tone mask and a method of forming an ion implantation pattern using the mask will be described.

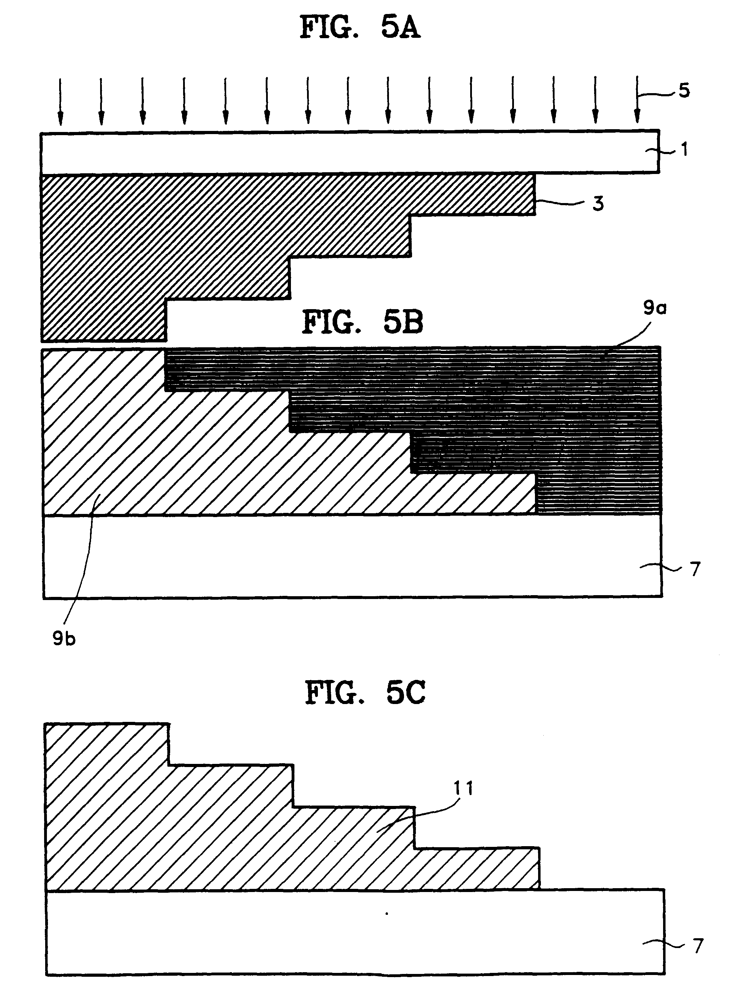

FIGS. 5A-5C illustrates a further example of a gray-tone mask according to the present invention and a process for the formation of a photoresist layer pattern as a mask layer on a substrate by using the mask.

As shown in FIG. 5A, gray-tone mask pattern 3 of optical absorbing material with variable thickness is formed on mask substrate 1. When light 5 is irradiated on the photo mask, photoresist layers 9a and 9b of photosensitive material formed on a wafer (substrate) 7 are selectively chemically changed. Here, if layers are of positive-tone photoresist, the chemical reaction occurs in the 9a region only. Thus, when the substrate of FIG. 5B is developed, a photoresist pattern 11 being staircase-like in shape is formed as shown in FIG. 5C.

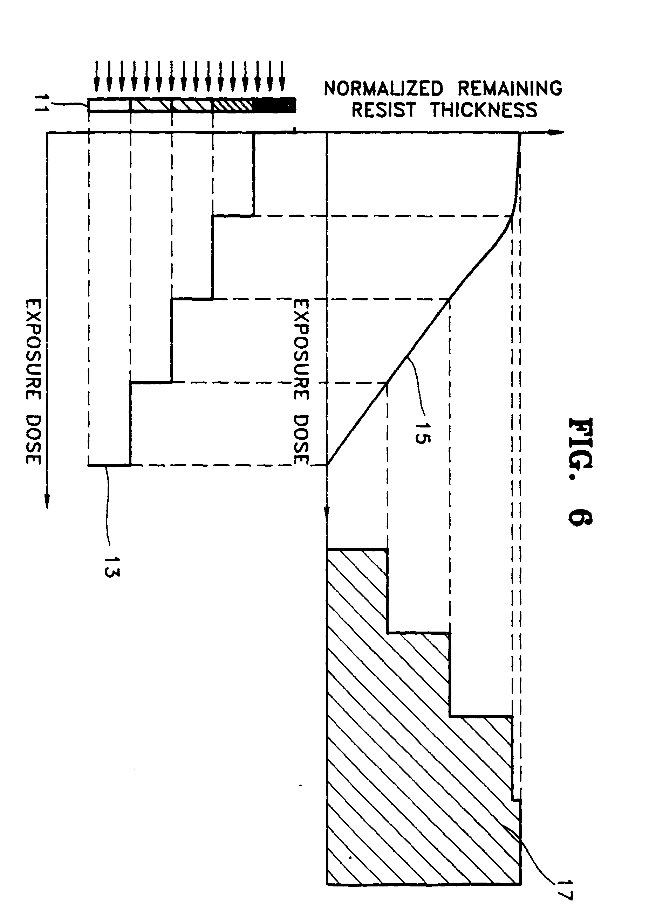

Referring to FIG. 6, the correlation between the exposure dose for developing the photoresist layer formed on the substrate and the remaining photoresist thickness will be described. Here, the.optical density transmitting through gray-tone mask 11 has an intensity profile 13, in which the optical intensity is low in the heavily hatched portion and high in the non-hatched portion. The mask having this optical distribution is developed with different levels via a photoresist layer characteristic curve 15, thereby forming a photoresist layer pattern 17 with varying thickness.

Next, an ion implantation method according to the present invention will be described.

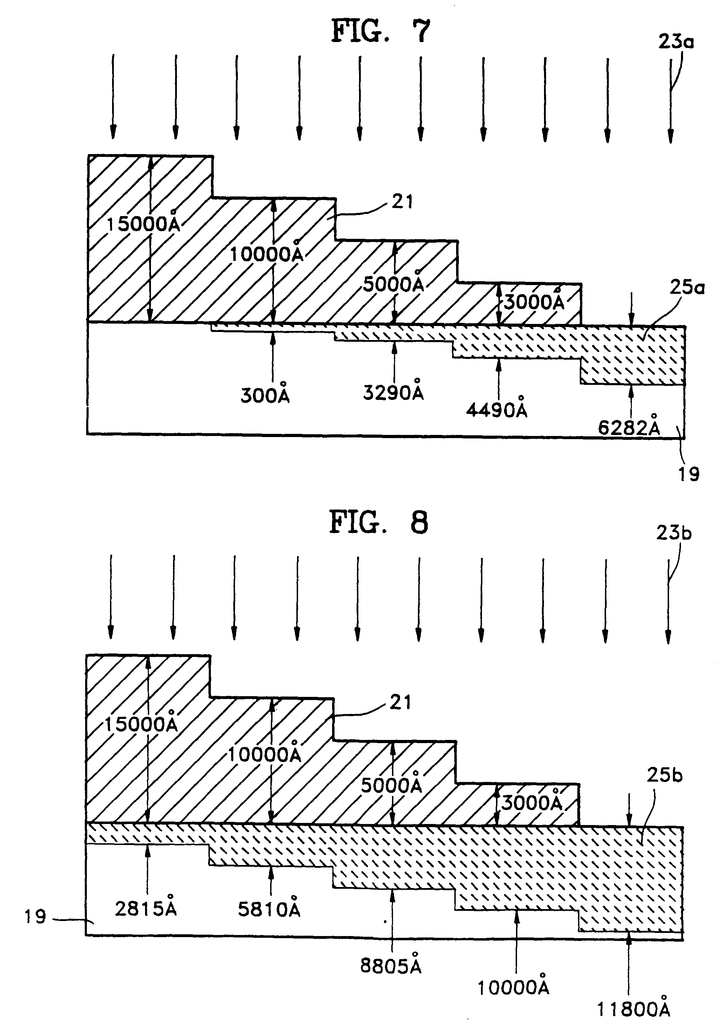

FIGS. 7 and 8 illustrate the step of implanting ions on the overall surface of a semiconductor substrate on which the ion implantation mask layer is formed, according to the first preferred embodiment of the present invention.

In detail, a photoresist layer pattern 21 having a staircase-like shape is formed on a substrate 19 using a gray-tone mask according to an embodiment of the present invention. Photoresist layer pattern 21 is then used as a mask layer for ion implantation. Moreover, according to a particularly preferred embodiment of the present invention, the varied thicknesses of photoresist layer pattern 21 are 15,000Å, 10,000Å, 5,000Å and 3,000Å. When fluoride ions 23a and boron ions 23b are implanted on the whole surface of the substrate on which photoresist layer pattern 21 is formed with an acceleration voltage of 500KeV, the implanted ions (charged particles) pass through thinner parts of photoresist layer pattern 21 and are then implanted in the wafer (substrate), thereby forming charged regions 25a and 25b. However, the ions cannot pass through thicker parts of photoresist pattern 21, and will remain at a certain depth within the pattern.

Here, the depth of ion implantation within the substrate was calculated using a simulator, determined according to the following formula.

$$R_p = k(R_s/R_r)(R_r - T_{rr})$$

wherein $R_p$ represents the depth of ions implanted in the substrate, $R_s$ represents the depth to which ions would be implanted in the substrate when there is no mask layer (photoresist layer pattern), $R_r$ represents the depth to which ions would be implanted in the photoresist pattern, $T_{rr}$ represents the thickness of the photoresist pattern remaining on the substrate, and k is a constant.

For example, as shown in FIG. 7, when $P^+$ ions are implanted with an acceleration voltage of 500KeV, the ions are implanted to a depth of 6,282Å (measured using a simulator) from the surface of the substrate in the region without any photoresist. The depth of ions implanted through the photoresist layer of 5,000Å thickness is 3,290Å, which is calculated from the above formula, wherein $R_s$ is 6,282Å, $R_r$ is 10,500Å and $T_{rr}$ is 5,000Å. Thus, it is shown that, when $P^+$ ions are implanted, the depth of ions implanted through the region of the pattern without a photoresist layer pattern on the substrate is 6,282Å. Also, in the respective cases when the thickness of the remaining photoresist layer is 3,000Å, . 5,000Å, 10,000Å and 15,000Å, the ion depth is 4490Å, 3,290Å, 300Å and 0Å, respectively.

As shown in FIG. 8, when $B^+$ ions are implanted, the depth of implantation in the portion of the substrate having no photoresist layer thereon is 11,800Å. Also, when the thickness of the remaining photoresist layer is 3,000Å, 5,000Å, 10,000Å and 15,000Å, the implantation depth is 10,000Å, 8,805Å, 5,810Å and 2,815Å, respectively.

FIGS. 9A-9E illustrate the step of implanting ions with varying methods of forming the ion implantation mask layer, according to the second preferred embodiment of the present invention.

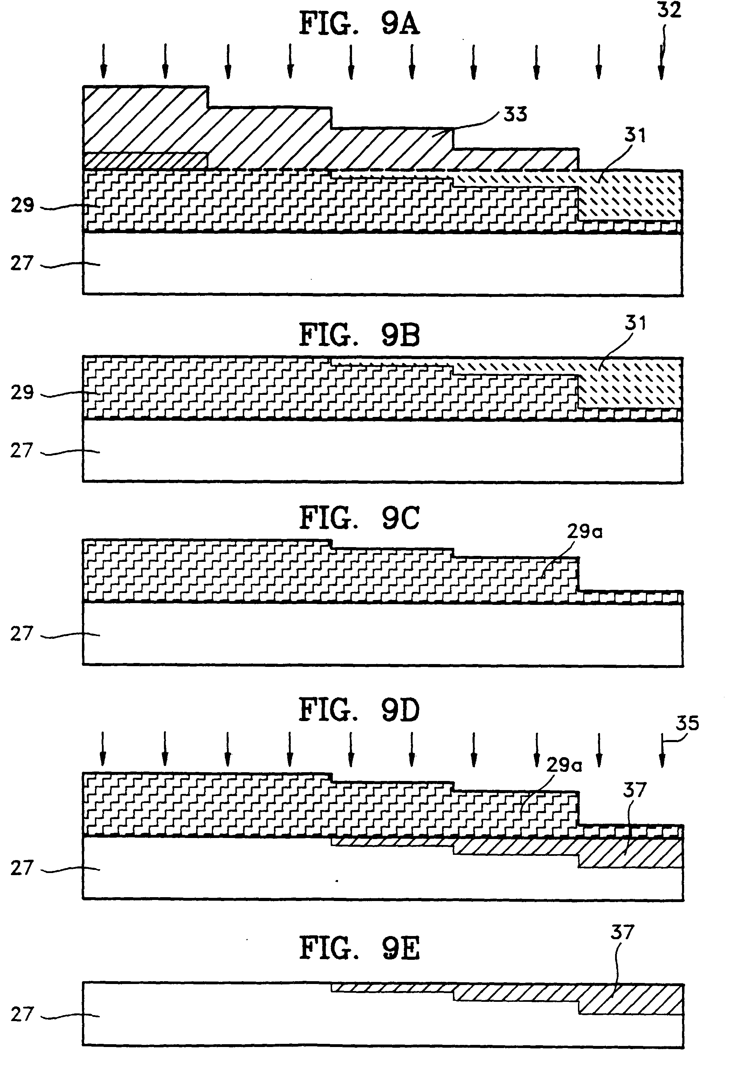

Here, as shown in FIG. 9A, a mask layer 29 is deposited on a semiconductor substrate 27 and then a first ion implantation 32 is performed on the whole surface of a photoresist layer pattern 33 formed by the gray-tone mask. Then, photoresist layer pattern 33 is removed (see FIG. 9B). As a result, the lattice of the ion-implanted portion 31 is damaged and dopant is included therein, thereby enabling ion-implanted portion 31 to be quickly removed during a wet or dry etching process. That is, ion-implanted portion 31 is selectively removed and an ion implantation mask pattern 29a is formed as shown in FIG. 9C. After this, a second ion implantation 35 is performed as shown in FIG. 9D and ion implantation mask pattern 29a is removed. An impurity region 37 is thereby formed on the semiconductor substrate as shown in FIG. 9E, in which the ions are implanted with differing depth. Mask layer 29 may consist of silicon, silicon oxide, silicon nitride or aluminum, and the thickness of mask layer 29 is selectively determined according to the intended ion depth.

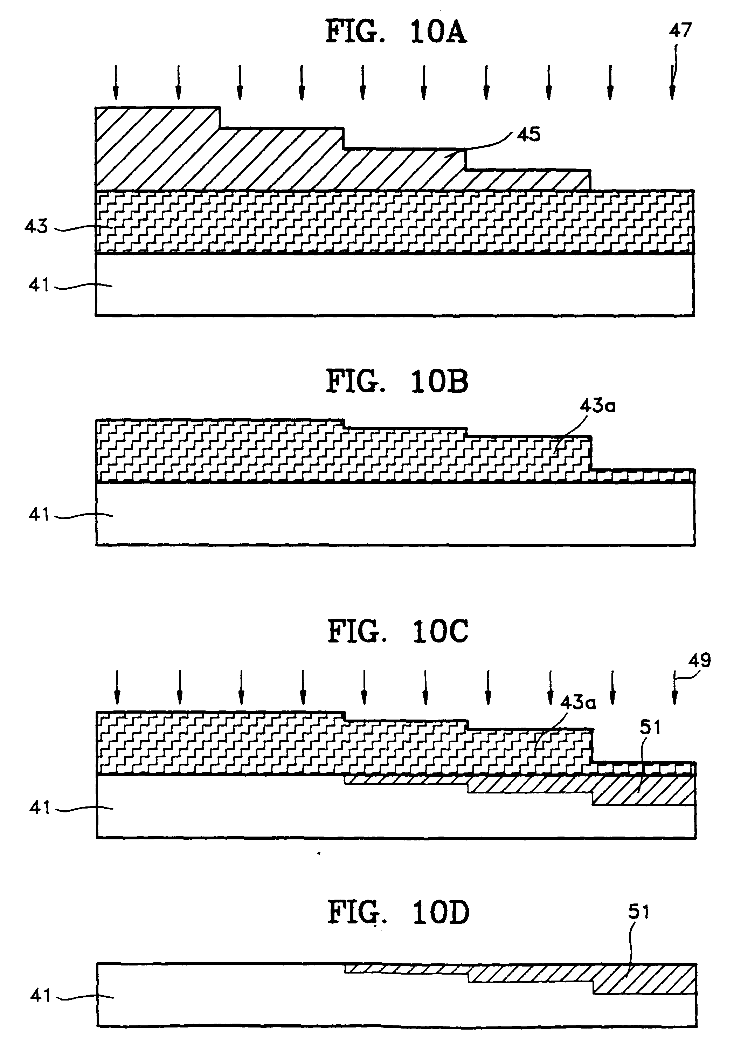

FIGS. 10A-10D illustrate the step of implanting ions with varying methods of forming the ion implantation mask layer, according to the third preferred embodiment of the present invention.

After forming a mask layer 43 on a semiconductor substrate 41, a photoresist layer pattern 45 is formed having different steps. A first ion implantation 47 is then performed on the whole surface of photoresist layer pattern 45. Photoresist layer pattern 45 and mask layer 43 are etched without selectivity. In consequence, an ion implantation mask pattern 43a is formed by an etch-back process. Thereafter, as shown in FIG. 10C, a second ion implantation 49 is performed such that an impurity region 51 is formed on semiconductor substrate 41. FIG. 10D shows ion implantation mask pattern 43a removed and impurity region 51 remaining, in which the ions are implanted at different depths. Here, ion implantation mask pattern 43a may consist of silicon, silicon oxide, silicon nitride or aluminum, and the thickness of ion implantation mask pattern 43a is determined selectively according to the intended ion depth.

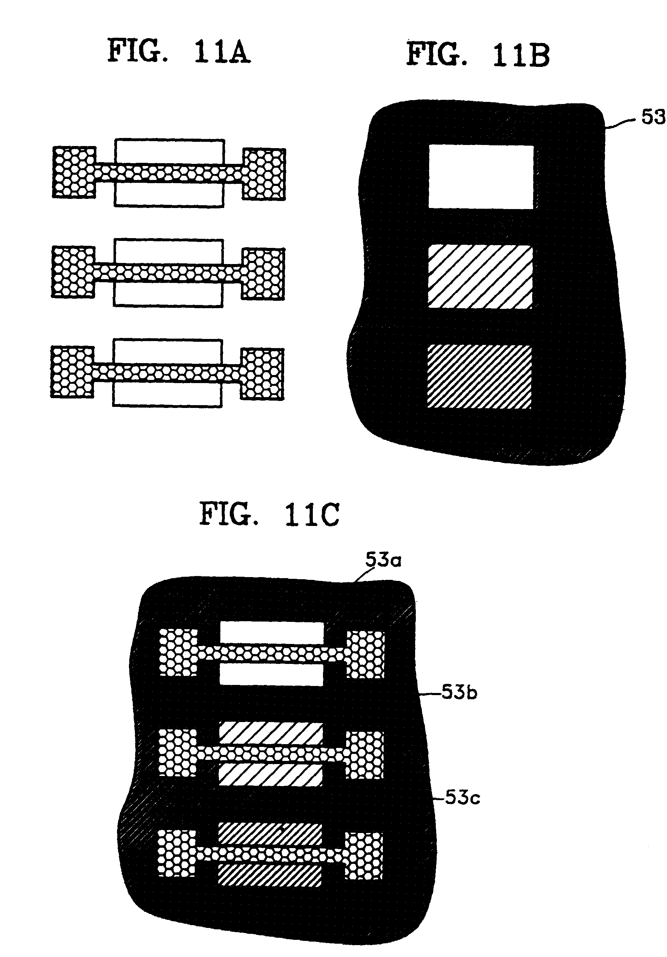

FIGS. 11A-11C show an example of an actual semiconductor device employing the ion implantation method according to the present invention.

When ions are implanted in three transistors (FIG. 11A), transistors 53a, 53b and 53c ion-implanted with different dosages can be obtained by using a gray-tone mask 53 as shown in FIG. 11B. This is shown in FIG. 11C. Thus, according to the present invention, three patterns, each of which have a different dosage, can be ion-implanted by using one gray-tone mask.

As described above, according to the present invention, an ion implantation mask pattern is formed on a semiconductor substrate using a mask having an optical absorbing material with multiple steps, so that the depth of the ions implanted in the semiconductor substrate can be varied and the number of masks required for ion implantation processing is reduced.

While the present invention has been illustrated and described with reference to specific embodiments, this invention is not limited to the specific embodiments illustrated and further modifications and improvements will occur to those skilled in the art.

## Claims

1. A mask for transcribing a mask pattern on a semiconductor substrate using light, wherein said mask pattern includes a gray-tone mask pattern (103,105,107,109,3) in which optical transmittance varies in a selective manner, so that the transmittance of light passing through said mask is controlled to vary in a selective manner.

2. A mask as claimed in claim 1, wherein said gray-tone mask pattern (3) comprises a photoresist pattern with multiple steps.

3. A mask as claimed in claim 1, wherein said gray-tone mask pattern (3) comprises an optical absorbing material having multiple steps which differ in thicknesses.

4. A mask as claimed in claim 3, wherein said optical absorbing material is made of one selected from the group consisting of chromium (Cr), chromium oxide (CrO), molybdenum silicon oxide (MoSiO), polysilicon, silicon nitride ($Si_3N_4$), tungsten (W) and aluminum (Al).

5. A mask as claimed in claim 1, wherein said gray-tone mask pattern (105,107) has a plurality of light-passing openings for controlling the transmittance of light passing through said mask.

6. A mask as claimed in claim 5, wherein said openings have a polygonal shape which has at least three sides.

7. A mask as claimed in claim 5, wherein said openings have different sizes, so that said gray-tone mask pattern (105,107) is divided into a plurality of regions (105a,105b,105C,105d,105e; 107a,107b, 107c,107d,107e), each having a different transmittance.

8. A mask as claimed in claim 1, wherein said gray-tone mask pattern (109) has regions (109b,109c, 109d) patterned in alternately disposed stripes for passing light.

9. A mask as claimed in claim 8, wherein the width of stripes in each of said striped regions (109b,109c, 109d) is different, so that said gray-tone mask pattern is divided into a plurality of regions each having a different transmittance.

10. A method of forming a pattern on a semiconductor substrate using light and a mask, wherein said mask comprises a gray-tone mask (3,103,105,107,109) having selectively varied optical transmittance on a mask substrate, thereby forming a pattern (11) with multiple steps on said semiconductor substrate.

11. A method of forming a pattern on a semiconductor substrate using a mask as claimed in claim 10, wherein said gray-tone mask pattern (3) comprises a photoresist pattern with multiple steps.

12. A method of forming a pattern on a semiconductor substrate using a mask as claimed in claim 10, wherein said gray-tone mask pattern (3) comprises an optical absorbing material with multiple steps which differ in thickness.

13. A method of forming a pattern on a semiconductor substrate using a mask as claimed in claim 10, wherein said gray-tone mask pattern (105,107) has a plurality of light-passing openings, thereby forming a pattern by controlling the optical transmittance.

14. A method of forming a pattern on a semiconductor substrate using a mask as claimed in claim 10, wherein said gray-tone mask pattern (109) is constructed of regions with alternately disposed stripes for passing light, thereby forming a pattern by controlling the optical transmittance.

15. A method of implanting ions comprising the steps of:

forming an ion implantation mask pattern (21) on a semiconductor substrate, using a mask having a gray-tone mask pattern (3,103,105,107,109) whose optical transmittance is selectively varied; and implanting ions on the whole surface of the substrate having said ion implantation mask pattern (21), so that the depth of the implanted ions in said semiconductor substrate varies in a selected manner.

16. A method of implanting ions as claimed in claim 15, wherein said ion implantation mask pattern comprises a photoresist pattern having multiple steps.

17. A method of implanting ions as claimed in claim 15, wherein said gray-tone mask pattern comprises an optical absorbing material having multiple steps which differ in thickness.

18. A method of implanting ions as claimed in claim 15, wherein said gray-tone mask pattern (105,107) has a plurality of light-passing openings for controlling the transmittance of light passing through said mask.

19. A method of implanting ions as claimed in claim 15, wherein said gray-tone mask pattern (109) is constructed by regions patterned in alternately disposed stripes for passing light.

20. A method of implanting ions comprising the steps of:

forming a material layer (29), on a semiconductor substrate; forming a mask pattern (33) on said material layer (29) using a mask having a gray-tone mask pattern (3,103,105,107,109) whose transmittance is selectively varied; implanting ions on the whole surface of the substrate having said mask pattern (33), thereby providing different ion depths within said material layer (29); forming an ion implantation mask pattern (29a) with multiple steps by selectively etching said ion implanted material layer (31); and implanting ions on the whole surface of the substrate having said ion implanting mask pattern, thereby providing different ion depths (37) within said semiconductor substrate.

21. A method of implanting ions as claimed in claim 20, wherein said material layer (29) is made of one selected from the group consisting of polysilicon, oxide, silicon nitride and aluminum.

22. A method of implanting ions comprising the steps of:

forming a material layer on a semiconductor substrate; forming a mask pattern (45) on said material layer using a mask having a gray-tone mask patten (3,103,105,107,109) whose optical transmittance is selectively varied; implanting ions on the whole surface of said material layer; forming an ion implantation mask pattern (43a) with multiple steps by etching-back said mask pattern (45) and said material layer (43) without selectivity; and
implanting ions on the whole surface of the substrate having said ion implanting mask pattern, thereby providing different ion depths (51) within said semiconductor substrate.

23. A method of implanting ions as claimed in claim 22, wherein said mask pattern is composed of a photoresist.

24. A method of implanting ions on a semiconductor substrate using an ion implanting mask pattern as a mask, wherein said ion implanting mask pattern is formed using light and a mask having a gray-tone mask pattern (3,103,105,107,109) whose optical transmittance is selectively varied, and thereafter ion-implanting different impurities in said semiconductor substrate using one mask.

## FIG. 1A

100

103a    103b    103c    103d

## FIG. 1B

103a    103b    103c    103d    100e

# FIG. 2

105a     105b     105c     105d     105e

# FIG. 3

107a     107b     107c     107d     107e

# FIG. 4

109

109a    109b    109c    109d    109e

# FIG. 5A

5

1

3

# FIG. 5B

9a

9b

7

# FIG. 5C

11

7

FIG. 6

# FIG. 7

23a

15000Å

21

10000Å

5000Å

3000Å

25a

300Å

3290Å

4490Å

6282Å

19

# FIG. 8

23b

15000Å

21

10000Å

5000Å

3000Å

25b

19

2815Å

5810Å

8805Å

10000Å

11800Å

## FIG. 9A

32

33

31

29

27

## FIG. 9B

31

29

27

## FIG. 9C

29a

27

## FIG. 9D

35

29a

37

27

## FIG. 9E

37

27

# FIG. 10A

47

45

43

41

# FIG. 10B

43a

41

# FIG. 10C

49

43a

51

41

# FIG. 10D

51

41

# FIG. 11A

# FIG. 11B

# FIG. 11C